# EUROPÄISCHE PATENTSCHRIFT

(11) **EP 1 221 056 B1**
(45) Veröffentlichungstag und Bekanntmachung des Hinweises auf die Patenterteilung: **17.08.2005**
(21) Anmeldenummer: 00979375.3
(22) Anmeldetag: 22.09.2000
(51) Int. Cl.: G01R 1/067, G01R 15/18, G01R 15/06, H01R 13/24

(54) **SENSOR ZUM ERFASSEN VON HOCHFREQUENTEN SCHWINGUNGEN EINER ELEKTRISCHEN SPANNUNG UND ANORDNUNG EINES SOLCHEN SENSORS**
SENSOR FOR DETECTING HIGH-FREQUENCY OSCILLATIONS OF AN ELECTRICAL VOLTAGE AND AN ARRANGEMENT OF SUCH A SENSOR
CAPTEUR POUR DETECTER DES OSCILLATIONS HAUTE FREQUENCE D'UNE TENSION ELECTRIQUE, ET DISPOSITION D'UN TEL CAPTEUR

(30) Priorität: 12.10.1999 DE 19949172
(43) Veröffentlichungstag der Anmeldung: 10.07.2002
(73) Patentinhaber: SIEMENS AKTIENGESELLSCHAFT, 80333 München (DE)
(72) Erfinder: KOZIEL, Reinhold, 45470 Mülheim (DE)
(86) Internationale Anmeldenummer: PCT/DE2000/003318
(87) Internationale Veröffentlichungsnummer: WO 2001/027639

(56) Entgegenhaltungen:
- EP-A- 0 312 050
- DD-A- 257 904
- US-A- 5 641 315
- PATENT ABSTRACTS OF JAPAN vol. 1997, no. 05, 30. Mai 1997 (1997-05-30) -& JP 09 021842 A (KANSAI ELECTRIC POWER CO INC:THE;NISSIN ELECTRIC CO LTD), 21. Januar 1997 (1997-01-21)

## Beschreibung

Die vorliegende Erfindung betrifft einen Sensor zum Erfassen von hochfrequenten Schwingungen der elektrischen Spannung in einer Leitung, wobei der Sensor einen Kondensator aufweist, dessen erster Anschluß mit der Leitung in Verbindung bringbar ist.

Ein derartiger Sensor dient zum Erfassen von hochfrequenten Spannungsschwingungen in Kraftwerken. Aus unterschiedlichen Gründen kann es in Kraftwerken zu Entladungen und Durchschlägen kommen. Diese führen zu hochfrequenten Impulsen, die sich auf eine oder mehrere Leitungen übertragen. Zum Sicherstellen einer Energieversorgung mit hoher Qualität müssen diese Impulse erfaßt und ausgewertet werden.

Zum Erfassen derartiger Schwingungen sind Sensoren bekannt, die einen Kondensator aufweisen, dessen erster Anschluß mit der Leitung in Verbindung bringbar ist. Dem zweiten Anschluß dieses Kondensators ist ein Widerstand zugeordnet. Es können aber auch mehrere Widerstände zugeordnet werden. Der Spannungsabfall über den oder die Widerstände wird gemessen und zum Erfassen der hochfrequenten Schwingungen verwendet. Nachteilig bei den bekannten Sensoren ist, daß eine Reihe von separaten Komponenten benötigt wird. Der zum Anbringen dieser Komponenten erforderliche Platzbedarf ist vergleichsweise hoch. Auch die Montage ist kostenaufwendig.

In der EP 0 312 050 A wird ein Hochspannungsmessschaltkreis für Breitbandmessungen von in Hochspannungsanlagen auftretenden transienten Signalen vorgestellt. Der Messschaltkreis weist einen in einem Gehäuse untergebrachten Eingangsschaltkreis zur kapazitiven Ankopplung einer Leitung in einer Hochspannungsanlage auf. Der Eingangsschaltkreis ist mit einem Ausgangsschaltkreis über einen elektrisch abgeschirmten Anschluß verbunden. Der Messschaltkreis erzeugt Ausgangssignale, die von den transienten Signalen, die an einer Durchführung der Hochspannungsanlage auftreten, herrühren.

In der Patentschrift DD 275 904 A1 wird eine Tastsonde zum Prüfen von Leiterplatten beschrieben. Hierbei wird an einem Tastende eines Sondenkörpers ein zweifach axial gefedertes Rollelement drehbar angeordnet, so dass die Tastsonde während einer Kontaktierung auf einer Leiterplatte positioniert werden kann, wobei Unebenheiten berücksichtigt werden können.

Aufgabe der vorliegenden Erfindung ist es daher, einen Sensor bereitzustellen, der weniger Bauteile umfaßt, einen geringeren Platzbedarf aufweist und einfacher zu montieren ist.

Erfindungsgemäß wird diese Aufgabe bei einem Sensor der eingangs genannten Art dadurch gelöst, dass der Sensor zum Erfassen von hochfrequenten Schwingungen der elektrischen Spannung in einer Leitung ausgebildet ist, wobei der Sensor einen Kondensator aufweist, der einen ersten Anschluss und einen zweiten Anschluss aufweist, wobei der erste Anschluss mit einer Kontaktspitze verbunden ist, die mit der Leitung in Verbindung bringbar ist, und dem zweiten Anschluss eine Buchse zum Abführen eines gemessenen Signals und ein Stromwandler zugeordnet sind und wobei die Kontaktspitze in Richtung der Längsachse des Sensors verstellbar angeordnet ist und ein elastisch gelagertes Element zum Andrücken an die Leitung aufweist.

Der erfindungsgemäße Sensor ist kleiner als die bekannten Sensoren. Er kann als kompakte Einheit hergestellt werden und ist somit leicht zu montieren. Es müssen insbesondere nicht mehr separate Bauteile nacheinander montiert werden, so daß die Montage wesentlich vereinfacht und beschleunigt wird.

Vorteilhafte Ausgestaltungen und Weiterbildungen der Erfindung gehen aus den abhängigen Ansprüchen hervor.

Vorteilhaft ist dem zweiten Anschluß weiter eine Funkenstrecke zugeordnet, die parallel zu dem Stromwandler geschaltet ist. Bei Auftreten unzulässig hoher Belastungen tritt ein Kurzschluß in der Funkenstrecke auf und der Stromwandler wird vor Überlastung geschützt.

In vorteilhafter Weiterbildung ist der zweite Anschluß des Kondensators über den Stromwandler und die Funkenstrecke geerdet. Die von dem Kondensator aufgenommenen Schwingungen werden durch die Erdung abgeführt und nur das gemessene Signal abgegeben.

Nach einer vorteilhaften Weiterbildung ist das Element kugelförmig ausgebildet und mit einer Druckfeder belastet. Durch die Verwendung eines kugelförmigen Elements wird eine definierte Berührfläche zwischen dem Element und der Leitung bereitgestellt. Die zum Andrücken verwendete Druckfeder ist einfach herzustellen und zu montieren, so daß die Herstellungs- und Montagekosten sinken.

Die Position des Elements ist gegenüber dem Sensor verstellbar, insbesondere in Längsrichtung des Sensors. Hierdurch ist der Andruckabstand zwischen dem Element und der Leitung zur Anpassung an den jeweiligen Anwendungsfall einstellbar. Es kann insbesondere ein einziger Sensor für eine Reihe unterschiedlicher Anwendungsfälle verwendet werden.

Die Erfindung betrifft weiter eine Anordnung des obenstehend beschriebenen Sensors, an einer Leitung zum Erfassen von hochfrequenten Schwingungen der elektrischen Spannung, wobei die Leitung von einer Abschirmung umgeben ist. Der Kondensator des Sensors ist in einem Zwischenraum zwischen der Leitung und der Abschirmung angeordnet. Diese Anordnung erfordert nur einen geringen Platzbedarf, ist einfach zu montieren und bei bestehenden Anlagen nachrüstbar.

Der Sensor ist an der Abschirmung befestigt. Zusätzliche Bauelemente sind nicht erforderlich, so daß die Konstruktion und die Montage vereinfacht und verbilligt werden.

Vorteilhaft ist die Abschirmung zur Befestigung des Sensors mit einem Einsatz versehen. Dieser Einsatz ist bei bestehenden Abschirmungen nachrüstbar, so daß auch der erfindungsgemäße Sensor und die erfindungsgemäße Anordnung in bereits vorhandene Anlagen nachträglich eingebaut werden können.

Nach einer vorteilhaften Weiterbildung ist der Sensor an einer Anschlußplatte angeordnet, die an dem Einsatz befestigt ist. Der Sensor kann auf der Anschlußplatte vormontiert werden, die danach an der Abschirmung befestigt wird. Hierdurch wird die Montage beschleunigt.

In vorteilhafter Ausgestaltung ist die Buchse zum Abführen eines gemessenen Signals des Sensors von außerhalb der Abschirmung zugänglich. Kabel zum Abgreifen des gemessenen Signals können rasch und einfach an die Buchse angeschlossen und außerhalb der Abschirmung verlegt werden.

Gemäß einer vorteilhaften Ausgestaltung ist die Abschirmung geerdet. Es sind dann keine besonderen Sicherheitsmaßnahmen erforderlich, um eine Berührung der Abschirmung zu verhindern. Weiter kann die erfindungsgemäß vorgesehene Erdung des Kondensators über die Abschirmung erfolgen. Separate Erdungskabel sind nicht erforderlich.

Nachstehend wird die Erfindung anhand eines Ausführungsbeispiels näher beschrieben, das schematisch in der Zeichnung dargestellt ist. Dabei zeigt:
- FIG 1: eine schematisch dargestellte erfindungsgemäße Anordnung eines Sensors;
- FIG 2: eine schematische Darstellung der dem Sensor zugrunde liegenden Schaltung;
- FIG 3: eine vollständige schematische Darstellung der erfindungsgemäßen Anordnung; und
- FIG 4: eine vergrößerte Darstellung einer Kontaktspitze des Sensors.

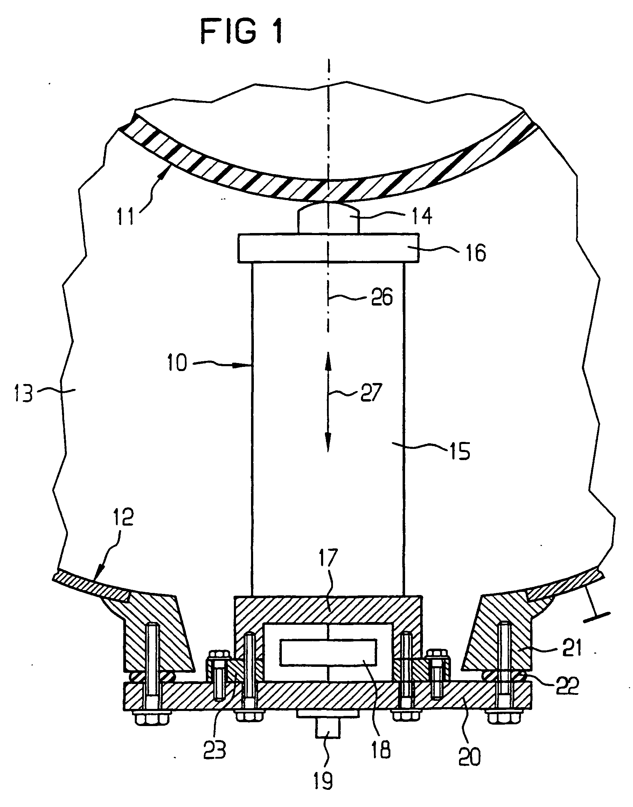

Figur 1 zeigt schematisch einen erfindungsgemäßen Sensor 10, der größtenteils in einem Zwischenraum 13 zwischen einer spannungsführenden Leitung 11 und einer geerdeten Abschirmung 12 aufgenommen ist. Der Sensor 10 umfaßt eine Kontaktspitze 14, einen Kondensator 15, der an beiden Seiten von Platten 16, 17 aus Aluminium eingefaßt ist, einen Stromwandler 18 sowie eine Buchse 19. Die Buchse 19 ist außerhalb der Abschirmung 12 angeordnet.

Die untere Platte 17 ist über eine isolierte Zwischenplatte 23 mit einer Anschlußplatte 20 verbunden. Die Zwischenplatte 23 dient zur Isolation des Kondensators 15. Zur Befestigung dienen schematisch dargestellte Schrauben.

Die Befestigung des Sensors 10 erfolgt über die Anschlußplatte 20 an einem Einsatz 21. Der Einsatz 21 ist auf nicht näher dargestellte Weise mit der Abschirmung 12 verbunden, beispielsweise über eine Schweißverbindung. Die Befestigung erfolgt wiederum mittels schematisch dargestellter Schrauben. Zwischen der Anschlußplatte 20 und dem Einsatz 21 sind eine oder mehrere Dichtungen 22 zur Abschirmung und Schwingungsdämpfung angeordnet.

Die Kontaktspitze 14 ist gemäß Pfeil 27 in Richtung einer Längsachse 26 des Sensors 10 verstellbar. Hierdurch kann der Andruckabstand zwischen der Kontaktspitze 14 und der Leitung 11 eingestellt werden.

Die Buchse 19 ist von außerhalb der Abschirmung 12 zugänglich, so daß zum Verlegen weiterer Kabel nur ein geringer Aufwand erforderlich ist. Weiter ist der gesamte Sensor 10 kompakt aufgebaut und kann vollständig zusammen mit der Anschlußplatte 20 vormontiert werden. Der Einsatz 21 kann in bereits bestehende Abschirmungen 12 nachgerüstet werden, so daß auch der erfindungsgemäße Sensor 10 mit nur geringem Aufwand nachträglich angebracht werden kann.

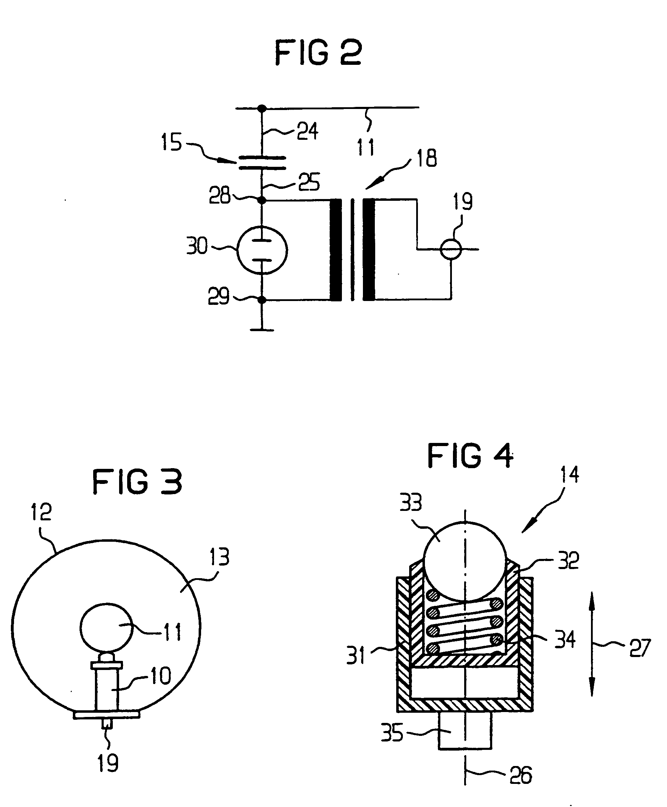

Figur 2 zeigt eine schematische Darstellung der verwendeten Schaltung. Der Kondensator 15 des Sensors 10 ist über einen ersten Anschluß 24 mit der Leitung 11 verbunden. Die Verbindung erfolgt über die Kontaktspitze 14. Dem zweiten Anschluß 25 des Kondensators 15 sind der Stromwandler 18 sowie die Buchse 19 und eine Funkenstrecke 30 zugeordnet. Die Funkenstrecke 30 ist parallel zu dem Stromwandler 18 zwischen dessen Anschlüsse 28, 29 geschaltet. Der Stromwandler 18 weist, wie jeder andere handelsübliche Stromwandler auch, eine Primär- und Sekundärseite auf. Stromabwärts des Anschlusses 29 ist eine Erdung vorgesehen.

In der Leitung 11 erfaßte Schwingungen der elektrischen Spannung erzeugen ein Signal, das über den Kondensator 15 und den Stromwandler 18 an die Buchse 19 abgegeben wird. Dort kann das Signal abgegriffen und einer nicht näher dargestellten Auswerteeinheit zugeführt werden. Bei unzulässig hohen Belastungen tritt ein Kurzschluß in der Funkenstrecke 30 auf. Beschädigungen des Stromwandlers 18 werden zuverlässig vermieden.

Figur 3 zeigt eine schematische Gesamtdarstellung der erfindungsgemäßen Anordnung des Sensors 10. Der Sensor 10 ist im Wesentlichen in dem Zwischenraum 13 aufgenommmen. Lediglich der Einsatz 21 sowie die Anschlußplatte 20 und die Buchse 19 stehen auswärts über die Abschirmung 12 vor. Der zum Anbringen des Sensors 10 zusätzlich erforderliche Platzbedarf ist somit minimal.

In Figur 4 ist die Kontaktspitze 14 des Sensors 10 vergrößert dargestellt. Die Kontaktspitze 14 weist ein Außengehäuse 31 auf, in dem ein Innengehäuse 32 aufgenommen ist. Das Außengehäuse 31 und das Innengehäuse 32 sind über ein nicht näher dargestelltes Gewinde miteinander verbunden. Durch eine Verdrehung des Innengehäuses 32 gegenüber dem Außengehäuse 31 findet somit eine Verstellung gemäß Pfeil 27 entlang der Längsachse 26 des Sensors 10 statt.

In dem Innengehäuse 32 ist eine Kugel 33 angeordnet, die von einer Druckfeder 34 belastet wird. Die Kugel 33 berührt in eingebautem Zustand die Leitung 11 und steht über einen Anschluß 35 mit dem ersten Anschluß 24 des Kondensators 15 in Verbindung. Eventuell auftretende Schwingungen der Spannung in der Leitung 11 werden von der Kugel 33 aufgenommen und über die Anschlüsse 35, 24 an den Kondensator 15 und von dort über den Stromwandler 18 an die Buchse 19 weitergeleitet. Durch die Verstellmöglichkeit in Richtung der Längsachse 26 gemäß Pfeil 27 läßt sich der Andruckabstand einstellen. Durch die Verwendung der Kugel 33 werden lokale Beschädigungen der Leitung 11 und Vergrößerungen der Kontaktfläche zwischen der Leitung 11 und der Kugel 33 vermieden. Hierdurch wird über längere Zeiträume eine im wesentlichen gleichbleibende Kontaktfläche gewährleistet.
Die Kapazität des Kondensators 15 sowie die Ausgestaltung des Stromwandlers 18 und der Funkenstrecke 30 hängen vom Einzelfall ab. Die Kapazität des Kondensators 15 kann allerdings im Regelfall kleiner als bei bestehenden Sensoren gewählt werden. Liegt an der Leitung 11 beispielsweise eine Spannung von 30 kV an, so ist erfindungsgemäß nur noch eine Kapazität von 10 nF gegenüber bisher 100 nF erforderlich. Die Funkenstrecke 30 wird in diesem Fall auf 400 V ausgelegt.

Der erfindungsgemäße Sensor 10 ist kompakt aufgebaut. Er kann rasch und einfach montiert werden. Das Anbringen separater Bauteile ist nicht mehr erforderlich. Mit der erfindungsgemäßen Anordnung wird der für das Anbringen des Sensors 10 erforderliche Platz wesentlich verringert. Weiter ist ein Nachrüsten in bereits bestehenden Anlagen mit minimalem Aufwand möglich.

## Patentansprüche

1. Sensor zum Erfassen von hochfrequenten Schwingungen der elektrischen Spannung in einer Leitung (11), wobei der Sensor (10) einen Kondensator (15) aufweist, der einen ersten Anschluß (24) und einen zweiten Anschluß (25) aufweist, wobei der erste Anschluß (24) mit einer Kontaktspitze (14) verbunden ist, die mit der Leitung (11) in Verbindung bringbar ist, und dem zweiten Anschluß (25) eine Buchse (19) zum Abführen eines gemessenen Signals und ein Stromwandler (18) zugeordnet sind und wobei die Kontaktspitze (14) in Richtung der Längsachse (26) des Sensors (10) verstellbar angeordnet ist und ein elastisch gelagertes Element (33) zum Andrücken an die Leitung (11) aufweist.

2. Sensor nach Anspruch 1,
bei dem dem zweiten Anschluß (25) eine Funkenstrecke (30) zugeordnet ist, die parallel zu der Primärseite des Stromwandlers (18) geschaltet ist.

3. Sensor nach Anspruch 2,
bei dem der zweite Anschluß (25) über die Primärseite des Stromwandlers (18) und die Funkenstrecke (30) geerdet ist.

4. Sensor nach einem der Ansprüche 1 bis 3,
bei dem das Element (33) kugelförmig ausgebildet und mit einer Druckfeder (34) belastet ist.

5. Anordnung des Sensors (10) nach einem der Ansprüche 1 bis 4 an einer Leitung (11) zum Erfassen von hochfrequenten Schwingungen der elektrischen Spannung in der Leitung (11), wobei die Leitung (11) von einer Abschirmung (12) umgeben ist,
**wobei** der Kondensator (15) des Sensors (10) in einem Zwischenraum (13) zwischen der Leitung (11) und der Abschirmung (12) angeordnet ist.

6. Anordnung nach Anspruch 5,
**wobei** die Abschirmung (12) zur Befestigung des Sensors (10) mit einem Einsatz (21) versehen ist.

7. Anordnung nach Anspruch 6,
**wobei** der Sensor (10) an einer Anschlußplatte (20) angeordnet ist, die an dem Einsatz (21) befestigt ist.

8. Anordnung nach einem der Ansprüche 5 bis 7,
**wobei** die Buchse (19) zum Abführen eines gemessenen Signals des Sensors (10) von außerhalb der Abschirmung (12) zugänglich ist.

9. Anordnung nach einem der Ansprüche 5 bis 8,
**wobei** die Abschirmung (12) geerdet ist.

## Claims

1. Sensor for detecting radio-frequency oscillations of the electrical voltage in a line (11), with the sensor (10) having a capacitor (15) which has a first connection (24) and a second connection (25), with the first connection (24) being connected to a contact point (14) which can be connected to the line (11), and the second connection (25) having an associated socket (19) for outputting a measured signal, and having an associated current transformer (18), and with the contact point (14) being arranged such that it can be adjusted in the direction of the longitudinal axis (26) of the sensor (10), and having an elastically mounted element (33) for pressing against the line (11).

2. Sensor according to Claim 1, in which the second connection (25) is associated with a spark gap (30), which is connected in parallel with the primary side of the current transformer (18).

3. Sensor according to Claim 2, in which the second connection (25) is earthed via the primary side of the current transformer (18) and the spark gap (30).

4. Sensor according to one of Claims 1 to 3, in which the element (33) is spherical and is loaded by a compression spring (34).

5. Arrangement of the sensor (10) according to one of Claims 1 to 4 on a line (11) for detecting radio-frequency oscillations of the electrical voltage in the line (11), with the line (11) being surrounded by a shield (12), with the capacitor (15) of the sensor (10) being arranged in an intermediate space (13) between the line (11) and the shield (12).

6. Arrangement according to Claim 5, with the shield (12) being provided with an insert (21) for attachment of the sensor (10).

7. Arrangement according to Claim 6, with the sensor (10) being arranged on a connecting plate (20) which is attached to the insert (21).

8. Arrangement according to one of Claims 5 to 7, with the bush (19) for outputting a measured signal from the sensor (10) being accessible from outside the shield (12).

9. Arrangement according to one of Claims 5 to 8, with the shield (12) being earthed.

## Revendications

1. Capteur de détection d'oscillations de haute fréquence de la tension électrique dans une ligne (11), le capteur (10) ayant un condensateur (15) qui a une première borne (24) et une deuxième borne (25), la première borne (24) étant reliée à une pointe (14) de contact qui peut être mise en liaison avec la ligne (11), et une prise (19) de sortie d'un signal mesuré et un convertisseur (18) de courant sont associés à la deuxième borne (25)et la pointe (14) de contact est montée réglable dans la direction de l'axe (26) longitudinal du capteur (10) et a un élément (33) monté élastiquement pour repousser la ligne (11).

2. Capteur suivant la revendication 1,
dans lequel à la deuxième borne (25) est associé un éclateur (30) qui est monté parallèlement au côté primaire du convertisseur (18) de courant.

3. Capteur suivant la revendication 2,
dans lequel la deuxième borne (25) est mise à la terre par l'intermédiaire du côté primaire du convertisseur (18) de courant et de l'éclateur (30).

4. Capteur suivant l'une des revendications 1 à 3,
dans lequel l'élément (33) est en forme de bille et est soumis à l'action d'un ressort (34) de compression.

5. Montage du capteur (10) suivant l'une des revendications 1 à 4 sur une ligne (11) pour la détection d'oscillations de haute fréquence de la tension électrique dans la ligne (11), la ligne (11) étant entourée d'un blindage (12),
dans lequel le condensateur (15) du capteur (10) est disposé dans un espace (13) intermédiaire compris entre la ligne (11) et le blindage (12).

6. Montage suivant la revendication 5,
dans lequel le blindage (12) est muni d'une pièce (21) rapportée pour la fixation du capteur (10).

7. Montage suivant la revendication (6),
dans lequel le capteur (10) est disposé sur une plaque (20) de connexion qui est fixée à la pièce (21) rapportée.

8. Montage suivant l'une des revendications 5 à 7,
dans lequel la prise (19) de sortie d'un signal mesuré du capteur (10) est accessible de l'extérieur du blindage (12).

9. Montage suivant l'une des revendications 5 à 8,
dans lequel le blindage (12) est mis à la terre.
